# FASCICULE DE BREVET EUROPEEN

(11) **EP 3 973 201 B1**
(45) Date de publication et mention de la délivrance du brevet: **03.01.2024**
(21) Numéro de dépôt: 20737513.0
(22) Date de dépôt: 15.05.2020
(51) Int. Cl.: C21D 6/00, C21D 9/08, C23C 14/58

(54) **ORGANE DE GUIDAGE, SYSTEME MECANIQUE COMPRENANT UN TEL ORGANE DE GUIDAGE, ET PROCEDE DE FABRICATION D'UN TEL ORGANE DE GUIDAGE**
FÜHRUNGSELEMENT, MECHANISCHES SYSTEM MIT EINEM SOLCHEN FÜHRUNGSELEMENT UND VERFAHREN ZUR HERSTELLUNG EINES SOLCHEN FÜHRUNGSELEMENTS
GUIDING MEMBER, MECHANICAL SYSTEM COMPRISING SUCH A GUIDING MEMBER, AND METHOD FOR PRODUCING SUCH A GUIDING MEMBER

(30) Priorité: 22.05.2019 FR 1905390
(43) Date de publication de la demande: 30.03.2022
(73) Titulaire: HYDROMECANIQUE ET FROTTEMENT, 42160 Andrézieux-Bouthéon (FR)
(72) Inventeur: PROST, Fabrice, 42000 SAINT-ETIENNE (FR); PAVALLIER, Pierrick, 42120 PERREUX (FR)
(74) Mandataire: Cabinet Laurent & Charras
(86) Numéro de dépôt international: PCT/FR2020/050810
(87) Numéro de publication internationale: WO 2020/234531

(56) Documents cités:
- EP-A1- 0 987 456
- WO-A1-2006/087498
- WO-A1-2006/111661
- WO-A1-2017/007397
- GB-A- 2 446 245
- CHEMKHI M ET AL: "The effect of surface mechanical attrition treatment on low temperature plasma nitriding of an austenitic stainless steel", SURFACE AND COATINGS TECHNOLOGY, ELSEVIER, NL, vol. 221, 14 February 2013 (2013-02-14), pages 191-195, XP028527067, ISSN: 0257-8972, DOI: 10.1016/J.SURFCOAT.2013.01.047

## Description

### DOMAINE TECHNIQUE

La présente invention concerne un organe de guidage, un système mécanique comprenant un tel organe de guidage, et un procédé de fabrication d'un tel organe de guidage.

Le domaine de l'invention est celui des systèmes mécaniques fonctionnant en oscillation, translation ou rotation sous fortes charges et soumis aux chocs en environnement abrasif.

### ART ANTERIEUR

De manière classique, un tel système comprend un organe de guidage et un élément mobile, comme décrit dans le document WO2006087498.

A titre d'exemple, le système peut former une articulation d'engin de travaux publics ou miniers, de véhicule agricole, de machine industrielle, etc.

Les bagues en bronze, en matériau composite ou en matériau polymère présentent l'avantage, lorsqu'elles sont soumises à des charges importantes, de pouvoir s'accommoder à la géométrie de l'axe et ainsi diminuer les pressions normales. La diminution du facteur p.V (produit de la pression diamétrale p en N/mm² par la vitesse circonférentielle V en m/s) entraine alors une diminution de l'usure de la bague.

En revanche, leur faible dureté de surface entraine une faible résistance à l'usure abrasive.

De ce fait, pour les applications soumises à des charges élevées et à une forte abrasion, il est d'usage d'utiliser des aciers avec des propriétés mécaniques importantes (Re > 800 MPa) et des duretés élevées. Ces aciers sont traités thermiquement et présentent une structure bainitique ou martensitique.

Cependant, du fait de leurs propriétés mécaniques importantes, ces bagues ne peuvent pas s'accommoder aux flexions d'axes. Cela entraîne des facteurs p.V localisés très importants, et par conséquent de l'usure puis du grippage.

WO2006/111661 A1 et WO 2017/007397 A1 divulguent des organes de guidage avec une couche blanche superficielle obtenue par nitruration ou carbonitruration permettant d'obtenir une surface dure résistante à l'usure. Les caractéristiques de l'organe de guidage de WO 2017/007397 A1 correspondent au préambule de la revendication 1.

### EXPOSE DE L'INVENTION

Le but de la présente invention est de proposer un organe de guidage amélioré, remédiant aux inconvénients ci-dessus.

A cet effet, l'invention a pour objet un organe de guidage, comprenant un corps muni d'un alésage pour le montage d'un élément mobile, le corps étant constitué d'un matériau métallique ferreux, le matériau métallique du corps présentant une limite élastique Re comprise entre 200 et 600 MPa, et l'alésage ayant une couche superficielle traitée contre le grippage sur une profondeur de diffusion inférieure ou égale à 0,6 mm. Selon l'invention, la couche superficielle présente une dureté supérieure ou égale à 500 Hv1 sur une profondeur comprise entre 5 et 50 µm et comprend une couche de combinaison, aussi appelée couche blanche, sur une profondeur comprise entre 5 et 50 µm, et une couche de diffusion à une profondeur inférieure ou égale à 0,6 mm, la couche superficielle comprenant une couche intermédiaire correspondant à une phase γN d'austénite enrichie en azote et présentant une dureté supérieure ou égalé à 500 Hv1 et située entre la couche de combinaison et la couche de diffusion.

Ainsi, l'invention permet d'obtenir un organe de guidage très performant dans le cadre des applications sous fortes charges et chocs en environnement abrasif, avec un excellent compromis entre résistance au grippage, résistance à l'abrasion et accommodation. L'organe de guidage présente des performances élevées, habituellement obtenues avec des catégories d'aciers nettement plus onéreuses, ainsi que des traitements de surface plus longs et plus profonds. La solution proposée est plus compétitive, avec un rapport performance / prix amélioré.

Selon d'autres caractéristiques avantageuses de l'invention, prises isolément ou en combinaison :
- Le matériau métallique est choisi parmi les aciers de construction ou les aciers faiblement alliés.
- Le matériau métallique présente une limite élastique Re comprise entre 300 et 600 MPa.
- Le matériau métallique présente une limite élastique Re comprise entre 400 et 500 MPa.
- La couche superficielle est traitée contre le grippage sur une profondeur de diffusion inférieure ou égale à 0,3 mm.
- La couche superficielle présente une dureté supérieure ou égale à 500 Hv1 sur une profondeur comprise entre 25 et 50 µm.
- La couche superficielle présente une dureté supérieure ou égale à 550 Hv1 sur une profondeur comprise entre 5 et 50 µm.
- La couche superficielle présente une dureté supérieure ou égale à 550 Hv1 sur une profondeur comprise entre 25 et 50 µm.

L'invention a également pour objet un système mécanique, comprenant un organe de guidage selon l'une des revendications précédentes, et un élément mobile disposé dans l'alésage de cet organe de guidage.

L'invention a également pour objet Procédé de fabrication d'un organe de guidage tel que décrit préceédemment, ledit organe de guidage comprenant un corps muni d'un alésage pour le montage d'un élément mobile, le procédé comprenant les étapes successives suivantes :
- fabriquer le corps en un matériau métallique ferreux présentant une limite élastique Re comprise entre 200 et 600 MPa ;
- réaliser un traitement de surface de l'alésage pour protéger l'organe de guidage contre le grippage, le traitement de surface affectant une couche superficielle de l'alésage sur une profondeur de diffusion inférieure ou égale à 0,6 mm, la couche superficielle présentant après le traitement de surface une dureté supérieure ou égale à 550 Hv1 sur une profondeur comprise entre 5 et 50 µm, une couche de combinaison aussi appelée couche blanche sur une profondeur comprise entre 5 et 50 µm, une couche de diffusion à une profondeur inférieure ou égale à 0,6 mm et une couche intermédiaire correspondant à une phase yN d'austénite enrichie en azote, présentant une dureté supérieure ou égale à 500 Hv1 et située entre la couche de combinaison et la couche de diffusion.

### BREVE DESCRIPTION DES DESSINS

L'invention sera mieux comprise à la lecture de la description qui va suivre, donnée uniquement à titre d'exemple non limitatif et faite en référence aux dessins annexés sur lesquels :
[Fig. 1] la figure 1 est une coupe longitudinale d'un système mécanise conforme à l'invention, comprenant un organe de guidage conforme à l'invention, et un élément mobile.
[Fig. 2] la figure 2 est une vue à plus grande échelle du détail II à la figure 1.

### DESCRIPTION DETAILLEE DE L'INVENTION

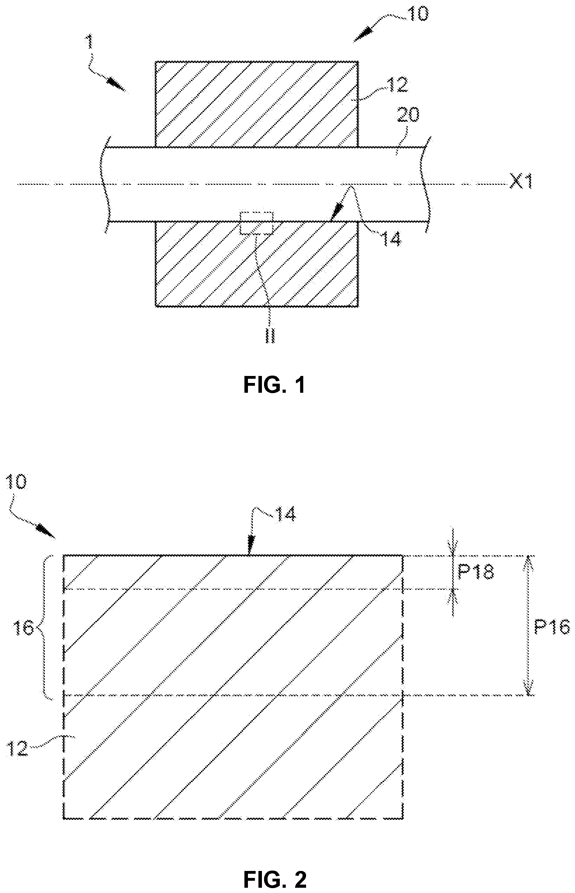

Sur les figures 1 et 2 est représenté un système mécanique 1 conforme à l'invention, comprenant une bague 10 conforme à l'invention, et un arbre 20 disposé dans la bague 10 suivant un axe longitudinal X1.

Le système 1 est conçu pour supporter de fortes charges et/ou des chocs en environnement abrasif. Le système 1 constitue par exemple une articulation d'engin de travaux publics ou miniers, de véhicule agricole, de machine industrielle pour la sidérurgie, etc.

La bague 10 comprend un corps 12 et un alésage 14 de profil cylindrique formé dans le corps 12. L'alésage 14 est prévu pour recevoir l'arbre 20, mobile en rotation autour de l'axe X1 et/ou en translation suivant l'axe X1, selon un mouvement continu ou alternatif. La bague 10 constitue un organe de guidage de l'arbre 20 en rotation et/ou translation.

L'interface de frottement entre la bague 10 et l'arbre 20, plus précisément entre l'alésage 14 et la surface externe de l'arbre 20, est de préférence lubrifiée. L'alésage 14 peut être lisse ou comporter des cavités faisant office de réserve de lubrifiant, comme décrit dans les documents EP0987456 et WO2006087498.

Le corps 12 est constitué d'un matériau métallique présentant une limite élastique Re comprise entre 200 et 600 MPa. Avantageusement, le matériau métallique peut être choisi parmi les aciers de construction ou les aciers faiblement alliés (comprenant au moins 95% de fer et de carbone). Cela réduit fortement le coût de fabrication de la bague 10, tout en procurant plusieurs avantages, détaillés ci-après. Le matériau métallique présente une limite élastique Re comprise de préférence entre 300 et 600 MPa, encore de préférence entre 400 et 500 MPa.

A titre d'exemples non limitatifs, le matériau du corps 12 peut être choisi parmi les matériaux métalliques suivants :

**[Tableau 1]**

| Nuance normalisée | Limite élastique à la traction Re (en PMa) | Catégorie |
|---|---|---|
| S235 | 235 | Acier d'usage général |
| S335 | 335 | Acier d'usage général |
| E295 | 295 | Acier de construction mécanique |
| S355 | 355 | Acier de construction mécanique |
| 34 Cr Mo 4 | 450 à 600 | Acier faiblement allié |

Selon l'invention, l'alésage 14 a une couche superficielle 16 traitée contre le grippage sur une profondeur de diffusion P16 inférieure ou égale à 0,3 mm. La couche superficielle 16 présente une dureté supérieure ou égale à 500 Hv1 sur une profondeur P18 comprise entre 10 et 50µm. La dureté peut être comprise entre 500 et 650 Hv1, en étant de préférence supérieure à 550 Hv1. La profondeur P18 est de préférence comprise entre 20 et 50 µm. Par exemple, la profondeur de diffusion P16 du traitement de surface anti-grippage appliqué à l'alésage 14 peut être de 0,2 mm, avec une dureté égale à 600 Hv1 sur une profondeur P18 de 30µm. Les profondeurs P16 et P18 ne sont pas à l'échelle sur la figure 2 dans un but de simplification.

De préférence, le traitement anti-grippage est une nitruration.

Si la profondeur P18 durcie est trop faible (< 10 µm), l'endurance à l'usure est trop réduite. Si la profondeur P18 est trop importante (> 50 µm), la couche superficielle 16 devient fragile et moins résiliente, donc sujette à l'écaillage, et présente une capacité d'accommodation plus réduite.

La profondeur de diffusion P16 du traitement de surface anti-grippage est limitée à 0,3 mm afin de conserver les propriétés d'accommodation maximale. Le traitement de surface aura ainsi l'avantage de ne pas s'écailler lorsqu'il sera soumis à des compressions de 4% minimum.

Selon l'invention, la couche superficielle 16 présente une dureté supérieure ou égale à 500 Hv1, encore de préférence supérieure ou égale à 550 Hv1, sur une profondeur P18 comprise entre 25 et 50 µm. Une profondeur d'au moins 25 µm permet d'augmenter encore davantage la durée de vie de l'organe de guidage, en augmentant l'endurance à l'usure.

Selon l'invention, la couche superficielle 16 traitée contre le grippage comprend une couche de combinaison (aussi appelée couche blanche) à la profondeur P18, et une couche de diffusion à la profondeur P16.

Selon l'invention, la couche superficielle 16 traitée contre le grippage comprend en outre une couche intermédiaire, située entre la couche de combinaison et la couche de diffusion.

La couche intermédiaire est de préférence située à une profondeur comprise entre 20 et 50 µm, et de manière davantage préférée entre 25 et 50 µm. Une profondeur P18 d'au moins 25 µm prolonge la durée de vie de la couche intermédiaire, donc celle de l'élément de guidage également, en augmentant la résistance à l'usure. Une profondeur de 50 µm ou moins augmente la résilience de la couche intermédiaire, donc celle de l'élément de guidage également, améliore la capacité d'accommodation, et limite l'écaillage.

La couche intermédiaire présente une dureté supérieure ou égale à 500 Hv1, de préférence supérieure ou égale à 550 Hv1, sur une profondeur P18 comprise entre 20 et 50 µm, de préférence entre 25 et 50 µm.

La couche intermédiaire se forme lors du traitement contre le grippage, notamment par nitruration ou carbonitruration, lorsque ledit traitement est réalisé à haute température, c'est-à-dire une température supérieure ou égale à 592°C.

La température de 592°C délimite la phase ferritique de la phase austénitique dans le diagramme fer-azote. Au-delà de 592°C, il se forme, selon l'invention, une phase γN (austénite enrichie à l'azote) qui correspond à la couche intermédiaire décrite précédemment.

Suite à un post-traitement de l'alésage 14, il est possible de contrôler la dureté de la couche intermédiaire. Avec un post-traitement à haute température, on peut aboutir à une couche intermédiaire de dureté élevé, tandis qu'avec un traitement à plus basse température, on peut aboutir à une couche intermédiaire de dureté plus basse. Parmi les post-traitements pouvant être mis en oeuvre, on peut citer notamment une oxydation, par exemple par bains de sels fondus entre 350°C et 500°C, une oxydation par voie gazeuse entre 350°C et 500°C, ou encore une oxydation dans une saumure à ébullition entre 120°C et 160°C.

Comme les matériaux métalliques s'écrouissent lorsqu'ils sont soumis à des charges supérieures à leurs limites élastiques, une fois l'accommodation effectuée, la résistance à la charge des zones sollicitées mécaniquement sera plus grande.

Par rapport aux bagues en matériaux métalliques présentant des propriétés mécaniques importantes (Re > 600 MPa), l'utilisation d'une bague 10 en matériau métallique présentant des propriétés mécaniques moins importantes (Re < 600 MPa) permet de diminuer la pression normale à l'interface entre la bague 10 et l'arbre 20 par accommodation de leurs surfaces en regard, donc de diminuer le facteur p.V, donc de réduire l'usure au sein du système mécanique 1.

Le traitement de surface suit l'accommodation du matériau et apporte une dureté importante en surface, permettant d'avoir une bonne résistance à l'abrasion et une résistance au grippage.

De manière inattendue, le système mécanique 1 est finalement plus performant avec la bague 10 selon l'invention en matériau Re < 600 MPa qu'avec une bague en matériau Re > 600 MPa.

Par rapport aux bagues en matériaux composites et matériaux polymères, la bague 10 présente une meilleure résistance à la charge suite à l'écrouissage de la couche superficielle, et une meilleure résistance à l'abrasion grâce à la dureté de surface de la couche superficielle 16 soumise au traitement de surface.

Par rapport aux bagues en bronze (125 < Re < 175 Mpa), laiton (Re ≈ 180 Mpa), cupro-alu, la bague 10 présente une meilleure résistance à l'abrasion.

Par rapport aux bagues en acier durci dans la masse ou superficiellement (trempe par induction haute fréquence, cémentation), la bague 10 présente une meilleure résistance au grippage, et une meilleure capacité d'accommodation à la charge.

Par rapport aux bagues présentant un revêtement dur anti-grippage appliqué dans l'alésage (projection thermique, PVD, NI chimique, Cr dur...), nécessitant un matériau ayant des propriétés mécanique importante (Re > 600MPa) pour éviter l'écaillage du revêtement soumis à de l'abrasion et à des chocs, la bague 10 peut être en matériau métallique présentant des propriétés mécaniques moins importantes (Re < 600 MPa), ce qui procure les différentes avantages présentés ci-dessus.

On réalise un essai comparatif mettant en oeuvre deux systèmes mécaniques, comprenant une bague et un arbre mobile en rotation dans la bague pendant 1000 heures.

Lorsque la bague est en acier avec Re > 600 MPa, l'accommodation est insuffisante, les charges sont mal réparties, le facteur p.V est important aux emplacements où les charges sont maximales, conduisant à une usure importante de l'arbre.

Lorsque la bague 10 est conforme à l'invention, avec Re < 600 MPa et traitement de surface anti-grippage, l'accommodation est satisfaisante, les charges sont mieux réparties, le facteur p.V est limité, et on constate que l'usure de l'arbre 20 est bien inférieure au cas précédent.

On cherche à caractériser la bague 10 plus précisément en réalisant une coupe du corps 12 dans un plan radial. Cela permet de montrer l'écrouissage de la bague 10 et une augmentation de ses caractéristiques mécaniques. Le corps 12 a subi une déformation de 3%, c'est-à-dire que le diamètre de l'alésage 14 a augmenté de 3%. La dureté du corps 12, mesurée à 0.6 mm de la surface de l'alésage 14 déformé, passe de 295 Hv0.1 contre 265Hv0.1 avant l'essai, soit une limite élastique à la traction Re passant de 850MPa à 950MPa.

Par ailleurs, le système mécanique 1 peut être conformé différemment des figures 1 et 2 sans sortir du cadre de l'invention.

En variante non représentée, le système 1 peut comprendre un organe de guidage 10 différent d'une bague.

Selon une autre variante non représentée, le système 1 peut comprendre un élément 20 différent d'un arbre, cet élément 20 étant mobile dans l'organe 10 en rotation autour de l'axe X1 et/ou en translation suivant l'axe X1.

Selon une autre variante non représentée, l'organe 10 peut comporter plusieurs alésage 14 ayant une couche superficielle 16 conforme à l'invention.

En outre, les caractéristiques techniques des différents modes de réalisation et variantes mentionnés ci-dessus peuvent être, en totalité ou pour certaines d'entre elles, combinées entre elles dans le cadre des revendications ci-jointes. Ainsi, le système mécanique 1 et l'organe de guidage 10 peuvent être adaptés en termes de coût, de fonctionnalités et de performance.

## Revendications

1. Organe de guidage (10), comprenant un corps (12) muni d'un alésage (14) pour le montage d'un élément mobile (20), le corps (12) étant constitué d'un matériau métallique ferreux, le matériau métallique du corps (12) présentant une limite élastique Re comprise entre 200 et 600 MPa, et l'alésage (14) ayant une couche superficielle (16) traitée contre le grippage sur une profondeur de diffusion (P16) inférieure ou égale à 0,6 mm, la couche superficielle (16) présentant une dureté supérieure ou égale à 500 Hv1 sur une profondeur (P18) comprise entre 5 et 50 µm, et comprenant une couche de combinaison, aussi appelée couche blanche, sur une profondeur comprise entre 5 et 50µm, et une couche de diffusion à une profondeur inférieure ou égale à 0,6 mm,
**caractérisé en ce que** la couche superficielle comprend une couche intermédiaire correspondant à une phase γN d'austénite enrichie en azote, présentant une dureté supérieure ou égale à 500 Hv1 et située entre la couche de combinaison et la couche de diffusion.

2. Organe de guidage (10) l'une des revendications précédentes, **caractérisé en ce que** le matériau métallique est choisi parmi les aciers de construction ou les aciers faiblement alliés.

3. Organe de guidage (10) selon l'une des revendications précédentes, **caractérisé en ce que** le matériau métallique présente une limite élastique Re comprise entre 300 et 600 MPa.

4. Organe de guidage (10) selon l'une des revendications précédentes, **caractérisé en ce que** le matériau métallique présente une limite élastique Re comprise entre 400 et 500 MPa.

5. Organe de guidage (10) selon l'une des revendications précédentes, **caractérisé en ce que** la couche superficielle (16) est traitée contre le grippage sur une profondeur de diffusion (P16) inférieure ou égale à 0,3 mm.

6. Organe de guidage (10) selon l'une des revendications précédentes, **caractérisé en ce que** la couche superficielle (16) présente une dureté supérieure ou égale à 500 Hv1 sur une profondeur (P18) comprise entre 25 et 50 µm.

7. Organe de guidage (10) selon l'une des revendications 1 à 5, **caractérisé en ce que** la couche superficielle (16) présente une dureté supérieure ou égale à 550 Hv1 sur une profondeur (P18) comprise entre 5 et 50 µm.

8. Organe de guidage (10) selon l'une des revendications 1 à 5, **caractérisé en ce que** la couche superficielle (16) présente une dureté supérieure ou égale à 550 Hv1 sur une profondeur (P18) comprise entre 25 et 50 µm.

9. Système mécanique (1), comprenant un organe de guidage (10) selon l'une des revendications précédentes, et un élément mobile (20) disposé dans l'alésage (14) de cet organe de guidage (10).

10. Procédé de fabrication d'un organe de guidage (10) selon l'une quelconque des revendications 1 à 9, comprenant un corps (12) muni d'un alésage (14) pour le montage d'un élément mobile (20), le procédé comprenant les étapes successives suivantes :
- fabriquer le corps (12) en un matériau métallique ferreux présentant une limite élastique Re comprise entre 200 et 600 MPa ;
- réaliser un traitement de surface de l'alésage (14) pour protéger l'organe de guidage (10) contre le grippage, le traitement de surface affectant une couche superficielle (16) de l'alésage (14) sur une profondeur de diffusion (P16) inférieure ou égale à 0,6 mm, la couche superficielle (16) présentant après le traitement de surface une dureté supérieure ou égale à 550 Hv1 sur une profondeur (P18) comprise entre 5 et 50 µm, une couche de combinaison, aussi appelée couche blanche, sur une profondeur comprise entre 5 et 50µm, une couche de diffusion à une profondeur inférieure ou égale à 0,6 mm, et une couche intermédiaire correspondant à une phase γN d'austénite enrichie en azote, présentant une dureté supérieure ou égale à 500 Hv1 et située entre la couche de combinaison et la couche de diffusion.

## Patentansprüche

1. Führungsorgan (10), umfassend einen Körper (12), versehen mit einer Bohrung (14) zur Montage eines beweglichen Elements (20), der Körper (12) besteht dabei aus einem Eisenwerkstoff, der Metallwerkstoff des Körpers (12) weist eine Streckgrenze Re zwischen 200 und 600 MPa auf und die Bohrung (14) verfügt über eine Oberflächenschicht (16), behandelt zum Schutz vor Festfressen, mit einer Diffusionstiefe (P16) kleiner oder gleich 0,6 mm, die oberflächliche Schicht (16) weist eine Härte von größer oder gleich 500 Hv1 mit einer Tiefe (P18) zwischen 5 und 50 µm auf, außerdem umfasst der Körper eine Kombinationsschicht, auch weiße Schicht genannt, mit einer Tiefe zwischen 5 und 50 µm, und eine Diffusionsschicht mit einer Tiefe von kleiner oder gleich 2- p 0,6 mm,
**dadurch gekennzeichnet, dass** die oberflächliche Schicht eine Zwischenschicht umfasst, die einer mit Stickstoff angereicherten austenitischen Phase entspricht, die eine Härte von größer oder gleich 500 Hv1 aufweist und sich zwischen der Kombinationsschicht und der Diffusionsschicht befindet.

2. Führungsorgan (10) nach einem der vorangehenden Ansprüche, **dadurch gekennzeichnet, dass** der Metallwerkstoff ausgewählt wird aus Baustählen oder den niedrig legierten Stählen.

3. Führungsorgan (10) nach einem der vorangehenden Ansprüche, **dadurch gekennzeichnet, dass** der Metallwerkstoff eine Streckgrenze Re zwischen 300 und 600 MPa aufweist.

4. Führungsorgan (10) nach einem der vorangehenden Ansprüche, **dadurch gekennzeichnet, dass** der Metallwerkstoff eine Streckgrenze Re zwischen 400 und 500 MPa aufweist.

5. Führungsorgan (10) nach einem der vorangehenden Ansprüche, **dadurch gekennzeichnet, dass** die oberflächliche Schicht (16) gegen Festfressen in einer Diffusionstiefe (P16) kleiner oder gleich à 0,3 mm behandelt ist.

6. Führungsorgan (10) nach einem der vorangehenden Ansprüche, **dadurch gekennzeichnet, dass** die oberflächliche Schicht (16) eine Härte von größer oder gleich 500 Hv1 mit einer Tiefe (P18) zwischen 25 und 50 µm aufweist.

7. Führungsorgan (10) nach einem der Ansprüche 1-5, **dadurch gekennzeichnet, dass** die oberflächliche Schicht (16) eine Härte von größer oder gleich 550 Hv1 mit einer Tiefe (P18) zwischen 5 und 50 µm aufweist.

8. Führungsorgan (10) nach einem der Ansprüche 1-5, **dadurch gekennzeichnet, dass** die oberflächliche Schicht (16) eine Härte von größer oder gleich 550 Hv1 mit einer Tiefe (P18) zwischen 25 und 50 µm aufweist.

9. Mechanisches System (1), umfassend ein Führungsorgan (10) nach einem der vorangehenden Ansprüche und ein bewegliches Element (20), untergebracht in der Bohrung (14) dieses Führungsorgans (10).

10. Verfahren zur Herstellung eines Führungsorgans (10) nach irgendeinem der vorstehenden Ansprüche 1 bis 9, umfassend einen Körper (12), versehen mit einer Bohrung (14) für die Montage 15 eines beweglichen Elements (20), wobei das Verfahren die nachstehenden, aufeinanderfolgenden Schritte umfasst:
- Herstellung des Körpers (12) aus einem Eisenwerkstoff, mit einer Streckgrenze Re zwischen 200 und 600 MPa,
- Durchführung einer Oberflächenbehandlung der Bohrung (14) zum Schutz des Führungsorgans (10) gegen Festfressen, die Oberflächenbehandlung betrifft eine oberflächliche Schicht (16) der Bohrung (14) mit einer Diffusionstiefe (P16) kleiner oder gleich 0,6 mm, die oberflächliche Schicht (16) weist dabei nach der Oberflächenbehandlung ein Härte von größer oder gleich 550 Hv1 mit einer Tiefe (P18) zwischen 5 und 50 µm auf, eine Kombinationsschicht, auch weiße Schicht genannt, mit einer Tiefe zwischen 25 5 und 50 µm, eine Diffusionsschicht mit einer Tiefe kleiner oder gleich 0,6 mm, und eine Zwischenschicht, entsprechend einer mit Stickstoff angereicherten austenitischen Phase, die eine Härte größer oder gleich 500 Hv1 aufweist und sich zwischen der Kombinationsschicht und der Diffusionsschicht befindet.

## Claims

1. Guiding element (10), comprising a body (12) with a bore (14) for mounting a movable element (20), the body (12) being made of a ferrous metal material, the ferrous metal material of the body (12) having a yield strength Re ranging from 200 to 600 MPa, and the bore (14) having a surface layer (16) treated to prevent seizing on a diffusion depth (P16) less than or equal to 0.6 mm, the surface layer (16) having a hardness greater than or equal to 500 Hv1 to a depth (P18) ranging from 5 to 50 µm and comprising a combination layer, also referred to as a white layer, to a depth ranging from 5 to 50 µm, and a diffusion layer to a depth less than or equal to 0.6 mm, **characterized in that** the surface layer includes an intermediate layer corresponding to a γN phase of nitrogen-enriched austenite, having a hardness greater than or equal to 500 Hv1 and located between the combination layer and the diffusion layer.

2. Guiding element (10) according to any of the preceding claims, **characterized in that** the metal material is selected from structural steels or low-alloy steels.

3. Guiding element (10) according to any of the preceding claims, **characterized in that** the metal material has a yield strength Re ranging from 300 to 600 MPa.

4. Guiding element (10) according to any of the preceding claims, **characterized in that** the metal material has a yield strength Re ranging from 400 to 500 MPa.

5. Guiding element (10) according to any of the preceding claims, **characterized in that** the surface layer (16) is treated to prevent seizing to a diffusion depth (P16) less than or equal to 0.3 mm.

6. Guiding element (10) according to any of the preceding claims, **characterized in that** the surface layer (16) has a hardness greater than or equal to 500 Hv1 to a depth (P18) ranging from 25 to 50 µm.

7. Guiding element (10) according to any of claims 1 to 5, **characterized in that** the surface layer (16) has a hardness greater than or equal to 550 Hv1 to a depth (P18) ranging from 5 to 50 µm.

8. Guiding element (10) according to any of claims 1 to 5, **characterized in that** the surface layer (16) has a hardness greater than or equal to 550 Hv1 to a depth (P18) ranging from 25 to 50 µm.

9. Mechanical system (1), comprising a guiding element (10) according to any of the preceding claims, and a movable element (20) disposed in the bore (14) of this guiding element (10).

10. Method for manufacturing a guiding element (10) according to any of claims 1 to 9, comprising a body (12) with a bore (14) for mounting a movable element (20), the method comprising the following successive steps:
- manufacturing the body (12) from a ferrous metal material having a yield strength Re ranging from 200 to 600 MPa;
- performing a surface treatment of the bore (14) to protect the guiding element (10) against seizing, the surface treatment affecting a surface layer (16) of the bore (14) to a diffusion depth (P16) less than or equal to 0.6 mm, the surface layer (16) having a hardness greater than or equal to 550 Hv1 to a depth (P18) ranging from 5 to 50 µm, a combination layer, also referred to as a white layer, to a depth ranging from 5 to 50 µm, and a diffusion layer to a depth less than or equal to 0.6 mm, and an intermediate layer corresponding to a γN phase of nitrogen-enriched austenite, having a hardness greater than or equal to 500 Hv1 and located between the combination layer and the diffusion layer.
